# EUROPEAN PATENT SPECIFICATION

(11) **EP 1 612 609 B1**
(45) Date of publication and mention of the grant of the patent: **26.11.2008**
(21) Application number: 05447154.5
(22) Date of filing: 30.06.2005
(51) Int. Cl.: G03F 7/20

(54) **Method and apparatus for immersion lithography**
Methode und Apparat für Immersionslithographie
Méthode et appareil pour lithographie à immersion

(30) Priority: 01.07.2004 US 584541 P
(43) Date of publication of application: 04.01.2006
(73) Proprietor: INTERUNIVERSITAIR MICROELEKTRONICA CENTRUM ( IMEC), 3001 Leuven (BE)
(72) Inventor: Mertens, Paul, 2820 Bonheiden (BE); Fyen, Wim, 3360 Korbeek-Lo (BE)
(74) Representative: Van Malderen, Joëlle

(56) References cited:
- EP-A- 1 420 298
- WO-A-20/05003864
- US-A- 5 660 642
- JAFAR ET AL: "Separation of alcohol/water mixtures by pervaporation through zeolite A membranes" MICROPOROUS MATERIALS, ELSEVIER SCIENCE BV, AMSTERDAM, NL, vol. 12, no. 4-6, December 1997 (1997-12), pages 305-311, XP005204645 ISSN: 0927-6513
- OWA S ET AL: "Immersion lithography; its potential performance and issues" PROCEEDINGS OF THE SPIE, SPIE, BELLINGHAM, VA, US, vol. 5040, no. 1, 28 February 2003 (2003-02-28), pages 724-733, XP002294500 ISSN: 0277-786X

## Description

### Field of the invention

The invention relates to a method for immersion lithography. It further relates to an apparatus suitable for performing the method according to the invention.

### Background of the invention

Currently immersion lithography is applied in microelectronics. In this technique a pattern is projected on a semiconductor substrate coated with a photo resist layer, while the space in between the lens and the photo resist layer is filled with an immersion liquid (e.g. ultra pure water).

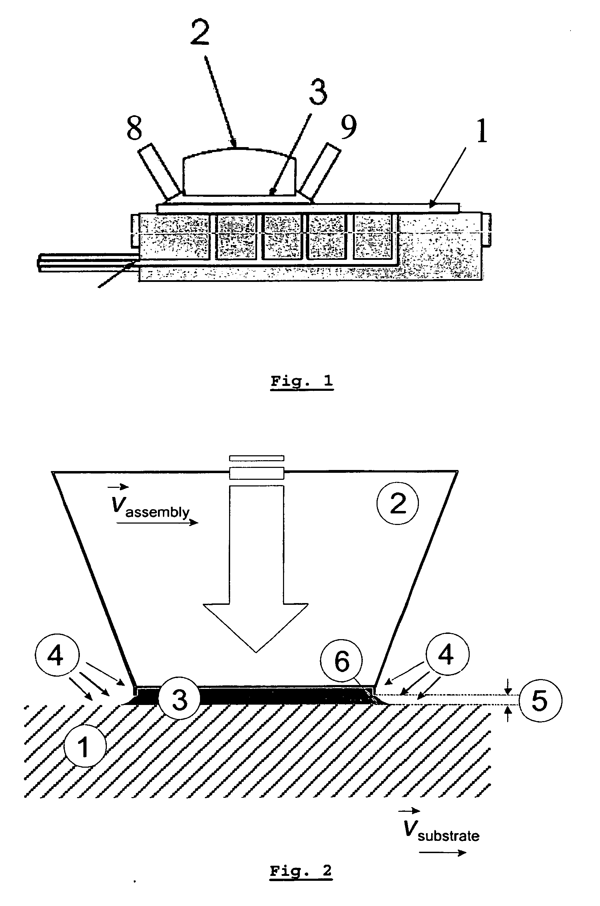

In a typical configuration the immersion liquid is supplied on one side of the optical immersion head assembly and drained at the other side of the optical immersion head assembly as shown in Figure 1 (presented by B.J. Lin on Arch Interface 2003). Typically the semiconductor substrate can move relative to the optical immersion head assembly, while the immersion liquid layer is maintained and kept confined in the zone under treatment.

One of the critical aspects in this process is the formation of gas bubbles at the interface between the photo resist and the substrate. Such gas bubbles have been found to be detrimental as they locally severely distort the optical beam. In order to suppress bubble formation the (dissolved) gas content of the liquid needs to be kept low.

Another important approach to minimize the bubble formation problem is to reduce the contact angle of the fluid on top of the photo resist layer, or in other words to improve the wetting of the photo resist by the immersion liquid. This can be done by using photo resist layers with a more liquid-philic (i.e. a liquid with a small contact angle) top surface. This approach in turn will make the confinement of the liquid to the zone under treatment much more difficult. It can result in undesired leakage from the zone between the optical immersion head assembly and the substrate. Such liquid left behind on the treated area then typically evaporates, which is undesirable.

In the field of wafer cleaning it is well established that improper wafer drying (involving a lot of evaporation) can typically lead to characteristic residues left behind often referred to as drying marks, or water marks.

Document WO2005/003864 (not published at priority date of present application) is related to a method for processing a substrate which includes generating a meniscus on the surface of the substrate and applying photolithography light through the meniscus to enable photolithography processing of a surface of the substrate.

Document EP1420298 is related to an immersion lithographic projection apparatus comprising a seal member surrounding a space between the final element of a projection system and a substrate table. A gas seal is further provided between the seal member and the substrate surface.

Document US5660642 illustrates the use of a Marangoni flow for removing a thin film of water remaining on the surface of an object following rinsing.

### Aim of the invention

The current invention provides extra latitude in the trade-off between gas-bubble formation because of poor wetting of the substrate by the immersion liquid on the one hand and the occurrence of immersion liquid leakage and liquid evaporation on the other hand. Furthermore, it reduces the risk of drying residue formation.

### Summary of the invention

In a first aspect of this invention, a method for immersion lithography is disclosed comprising the steps of
- positioning a semiconductor substrate under an optical immersion head assembly,
- providing an immersion liquid between the substrate and the optical immersion head assembly, the immersion liquid at least contacting an area of the substrate, characterized in that the method further comprises the steps of :
- supplying a tensio-active gaseous substance along the perimeter of the contact area of the immersion liquid and the substrate, whereby the tensio-active gaseous substance is chosen such that, when at least partially mixed with the immersion liquid, it yields a mixture with a lower surface tension than the immersion liquid, thereby creating a surface tension gradient pulling the immersion liquid from the perimeter towards the contact area wherein the presence of said tensio-active substance creates a three-phase region along said perimeter, and wherein the tensio-active gaseous substance is supplied with a gas flow directed to said three phase region and wherein the tensio-active gaseous substance is supplied separately in different sections along the perimeter of the contact area.

In a first embodiment of the first aspect of this invention, the immersion liquid is essentially water.

The tensio-active gaseous substance and its concentration have to be selected such that it is compatible with the photo resist. In an embodiment of the first aspect of this invention the tensio-active gaseous substance comprises isopropylalcohol (IPA), butanol, ethanol, hexanol or equivalent.

In a particular embodiment of the first aspect, the tensio-active gaseous substance comprises IPA vapor.

In another particular embodiment of the first aspect, the tensio-active gaseous substance comprises IPA vapor and a vapor of the immersion liquid.

In a preferred embodiment the tensio-active gaseous substance comprises a mixture of IPA and N₂ vapor. Further embodiments of the method of the invention are described in dependent claims 2-16.

In a second aspect of this invention an apparatus for immersion lithography is disclosed comprising :
- means for holding a substrate
- an optical immersion head assembly
- means for supplying an immersion liquid between the substrate and the optical immersion head assembly characterized in that said apparatus further comprises :
   means for supplying a tensio-active gaseous substance, arranged for providing a tensio-active gaseous substance along the perimeter of the contact area of the immersion liquid and the substrate, such that upon supply a surface tension gradient is created pulling the immersion liquid from the perimeter towards the contact arca, wherein the presence of said tensio-active substance creates a three-phase region along said perimeter, and wherein the means for supplying a tensio-active substance are arranged for supplying said substance with a gas flow directed to said three phase region, and wherein the means for supplying the tensio-active gaseous substance are separated in different sections along the perimeter of the contact area.

In an embodiment of the second aspect of this invention, the supply of the gaseous mixture is separated in different sections along the perimeter of the contact area. In each section the confinement of the immersion liquid can be optimized separately. As an example different sections are selected according to the local orientation of the perimeter with respect to the relative velocity vector (Vᵣₑₗ).

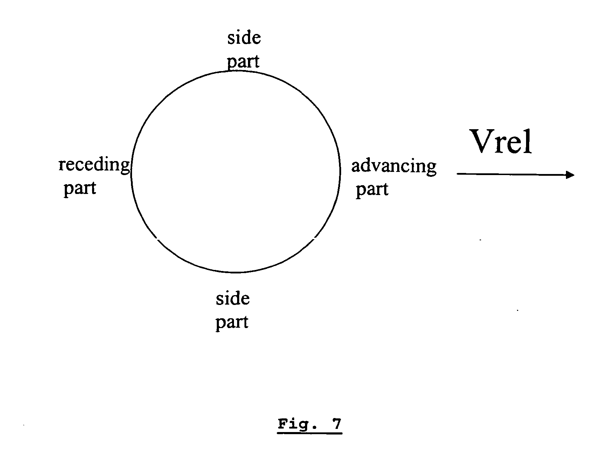

A possible division is in three different types of sections (figure 7). In order to describe this, we define the local normal vector as a vector that is locally perpendicular to the perimeter pointing outside of the contact area. These three types of sections are:
- a side part where the relative velocity is essentially parallel to the local tangent of the perimeter.
- an advancing part, where the relative velocity vector is essentially parallel to the local normal vector and essentially pointing into the same direction.
- a receding part where the relative velocity vector is essentially parallel to the local normal vector and essentially pointing into the opposite direction.

Further embodiments of the apparatus of the invention are described in dependent claims 18-25.

### Short description of the drawings

Figure 1: cross-sectional schematic of an immersion lithographic set-up

Figure 2: cross-sectional schematic according to the present invention

Figure 3: cross-sectional schematic of the invention using active directed supply of the tensio-active gaseous substance

Figure 4: cross-sectional schematic of the invention using a liquid feed-through supply

Figure 5: cross-sectional schematic of the invention using a liquid recirculation unit

Figure 6: cross-sectional schematic of the invention using a single-pass liquid supply system

Figure 7: Division of the contact area in three different types of regions.

### Detailed description of the invention

In relation to the appended drawings the present invention is described in detail in the sequel. It is apparent however that a person skilled in the art can imagine several other equivalent embodiments or other ways of executing the present invention.

The method and apparatus of the current invention is illustrated in figure 2.

A semiconductor substrate with photoresist (further called the substrate) to be treated (1) is mounted. This substrate can move in a plane essentially parallel to its surface with a velocity V_{substrate}. The optical immersion head assembly (2) is facing the surface of the substrate to be treated. This optical immersion head assembly can move with a velocity V_{assembly} in a plane parallel to the substrate surface. Thus a relative velocity of the substrate with respect to the optical immersion head assembly is Vᵣₑₗ = Vsubstrate - V_{assembly}.

In most cases the assembly is mounted stationary, thus V_{assembly} is kept 0. In general Vᵣₑₗ is not equal to 0, but at some time-intervals it can be temporarily 0.

The immersion liquid (3) is present in between the optical head assembly and the substrate.

A small gap (5) is present in between the substrate surface and the bottom of the optical immersion head assembly. Typically this gap is on the order of a few hundred micrometers to 1 or a few mm and assists the confinement of the immersion liquid.

A tensio-active gaseous substance (4) is present next to the small gap. Tensio-active gaseous substance being understood according to the present invention as a substance that, when mixed with a liquid, yields a mixture with lower surface tension than the liquid. The tensio-active gaseous substance can comprise a vaporized substance which is miscible with said liquid and when mixed with said liquid yields a mixture having a surface tension being lower than that of said liquid.

A vaporized substance is defined as a mist of finely dispersed liquid droplets of an element or a compound or a mixture of elements or as a vapor. A vapor is defined as a specific gas phase occurrence of an element or a compound or a mixture of elements. A vapor is a gas phase that can co-exist in one environment with the solid or liquid phase of the element.

Said gaseous substance can comprise a gas which is miscible with said liquid and when mixed with said liquid yields a mixture having a surface tension being lower than that of said liquid.

The tensio-active gaseous substance can comprise a mixture of a vaporized substance and a gas, particularly an inert gas like e.g. helium, argon or nitrogen, said mixture being at least partially miscible with said liquid and when mixed with said liquid yielding a mixture having a surface tension being lower than that of said liquid.

The presence of a tensio-active gaseous substance creates a three-phase region (6) (solid substrate, immersion liquid and gaseous substance) along the perimeter of the contact area of the immersion liquid to the substrate resulting in a surface tension gradient in the surface of the liquid phase. This surface tension gradient results in better confinement of the immersion liquid. Furthermore, the amount of liquid left behind on the surface at the receding part of the perimeter is reduced, particularly in case of surface with a more liquid-philic character.

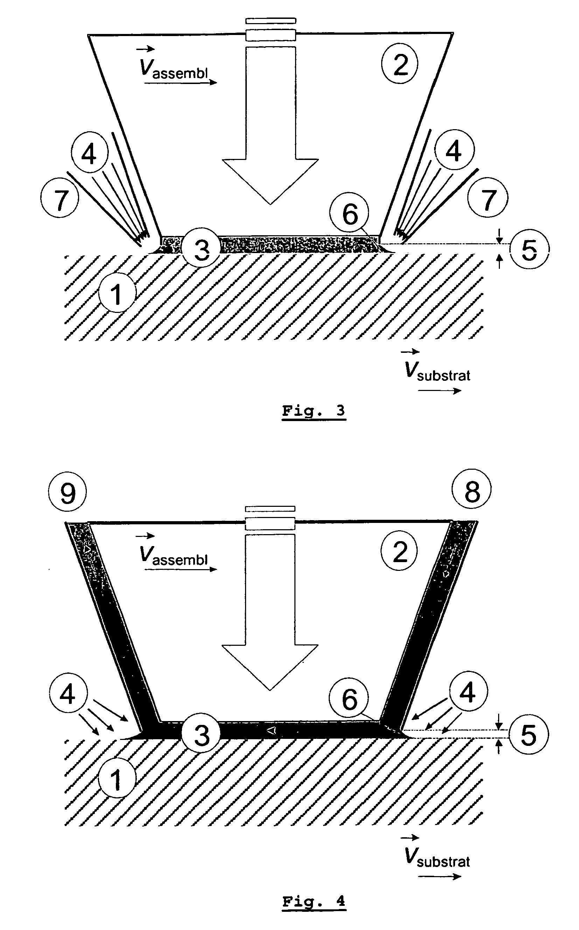

The tensio-active gaseous substance is chosen such that it can reduce the surface tension. Therefore the following properties are important:
- Sufficient surface tension reduction upon mixed into the immersion liquid
- Sufficiently soluble in the immersion liquid
- Compatible with the substrate (typically photoresist).
- Compatible with the optical requirements of the liquid, i.e. the concentrations used should not disturb the lithographic printing process through changes in refractive index.
According to the invention, the tensio-active gaseous substance may be present at the perimeter of the contact area. However, it was found that supplying the tensio-active gaseous substance with a gas flow well directed to the three-phase region further improves the confinement and drying capabilities. This can be obtained by dispensing the tensio-active gaseous substance through a well-designed supply providing a jet directed to the three-phase region. This can be obtained by using a concentric circle of nozzles or a nozzle with a narrow slit-shaped outlet (7) directed to the three-phase region (6), and mounted around the immersion head assembly as depicted in Fig 3. Adjacent to the slit-shaped nozzle, an exhaust channel (not shown in the figure) can be mounted in order to exhaust the excess of tensio-active gaseous substance.

In a method and apparatus according the invention the gaseous substance may be supplied separately in different sections along the perimeter of the contact area. In each section the confinement of the immersion liquid can be optimized separately by using separate nozzles in each section. The flow rate of the gaseous substance and/or the position of the nozzles directed to the perimeter of the contact area may be optimized in each section. As an example different sections are selected according to the local orientation of the perimeter with respect to the relative velocity vector (Vᵣₑₗ).

A possible division is in three different types of sections (figure 7). In order to describe this, we define the local normal vector as a vector that is locally perpendicular to the perimeter pointing outside of the contact area. These three types of sections are:
- a side part where the relative velocity is essentially parallel to the local tangent of the perimeter.
- an advancing part, where the relative velocity vector is essentially parallel to the local normal vector and essentially pointing into the same direction.
- a receding part where the relative velocity vector is essentially parallel to the local normal vector and essentially pointing into the opposite direction.

The immersion liquid can be supplied from a supply (8) and drained away on the other side (9) as shown in figure 4.

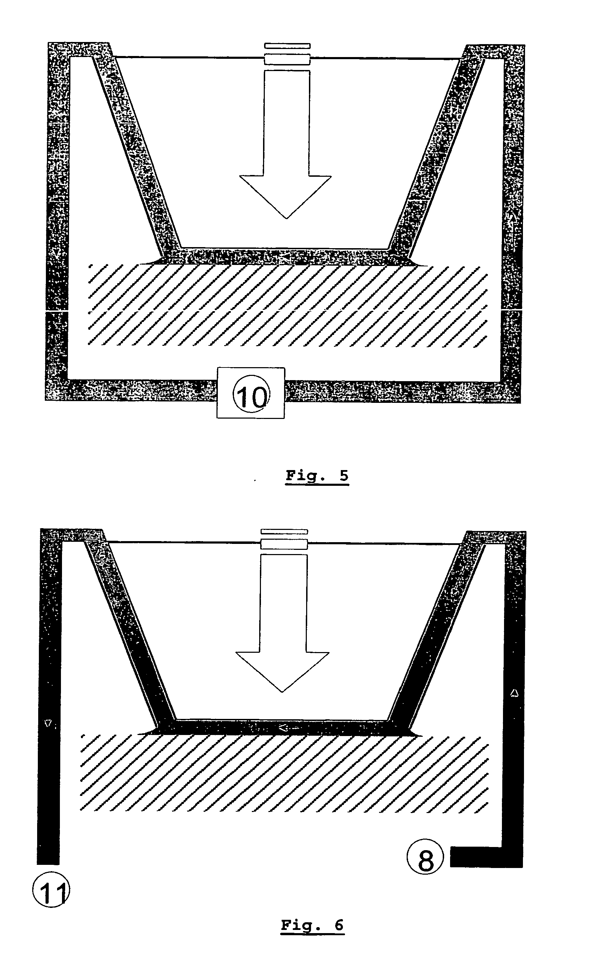

The immersion liquid could be used fresh and drained into a waste collection system (11) as shown in figure 6. Alternatively the immersion liquid could be reused through a recirculation device (10) as shown in figure 5. In this recirculation device the immersion liquid could be treated (e.g.regenerated, purified, filtered, degassed etc...) if needed. If recirculation is chosen, the lifetime of the immersion liquid will be determined by the build-up (loading) of dissolved tensio-active gaseous substance in this liquid. If a certain limit concentration is exceeded, the immersion liquid is not suited to be used anymore and needs to be replenished.

The tensio-active gaseous substance and its concentration have to be selected and optimized such that it is compatible with the photoresist. A high concentration of IPA as an example is known to partially dissolve some types of photoresist.

Typically the immersion liquid can essentially be water. In that case the gaseous substance can be one of the group consisting of isopropylalcohol (IPA), butanol, ethanol, hexanol, or equivalents, or a mixture thereof.

Preferably the immersion liquid is essentially water, while the tensio-active gaseous substance comprises a mixture of IPA vapor and immersion liquid vapor or a mixture of IPA vapor and N₂ vapor. The IPA vapor can be generated by bubbling N2 through liquid IPA, obtaining a mixture of IPA vapor and N₂ vapor.

A mist of gaseous substance can be generated by exposing its liquid phase to a high frequency (e.g. 1 MHz) acoustic agitation.

The higher the flow rate of the tensio-active gaseous substance, the higher the maximum relative velocity of the moving substrate with respect to the immersion head assembly. If in case of a flow of N₂ saturated with IPA a flow of N2 into the bubbler at a rate of 0.5 SLM (standard liter per minute) is used per cm length of the three-phase region, then the maximum relative velocity between immersion head assembly and substrate is approximately 8 mm/s.

Further advantage of this invention is that it reduces the amount of liquid left behind that can dry by evaporation, thereby reducing significantly the risk for watermark formation. No additional drying of the substrate is needed after immersion litho step.

Furthermore, it is now possible to have equipment parts that are not water compatible in the immersion litho tool, because the immersion liquid is confined between the immersion head assembly and the wafer, without the need of a fully immersed system.

### EXAMPLE

The feasibility of IPA assisted immersion scanning was demonstrated on hydrophilic Si surfaces, using an ASML 1150i immersion head.

During a first test, the immersion head assembly moves at a scan speed of 125 mm/s from left to right. No IPA is provided along the perimeter of the contact area of the immersion liquid to the wafer surface. After the movement, parallel lines of immersion liquid are left on the wafer surface.

During a second test, again the showerhead moves at a scan speed of 125 mm/s from left to right. IPA is indeed provided by a concentric circle of small nozzles along the perimeter of the contact area. Substantially no immersion liquid is left on the wafer surface.

## Claims

1. A method for immersion lithography comprising the steps of
- positioning a semiconductor substrate under an optical immersion head assembly,
- providing an immersion liquid between the substrate and the optical immersion head assembly, the immersion liquid at least contacting an area of the substrate,
**characterized in that** the method further comprises the step of :
- supplying a tensio-active gaseous substance along the perimeter of the contact area of the immersion liquid and the substrate, whereby the tensio-active gaseous substance is chosen such that, when at least partially mixed with the immersion liquid, it yields a mixture with a lower surface tension than the immersion liquid, thereby creating a surface tension gradient pulling the immersion liquid from the perimeter towards the contact area, wherein the presence of said tensio-active substance creates a three-phase region along said perimeter, and wherein the tensio-active gaseous substance is supplied with a gas flow directed to said three phase region and wherein the tensio-active gaseous substance is supplied separately in different sections along the perimeter of the contact area.

2. A method according to claim 1, wherein in each section the confinement of the immersion liquid is separately optimized.

3. The method according to claim 1 or 2, wherein the gaseous substance is supplied through separate nozzles in each of said different sections.

4. The method according to claim 3, wherein the flow rate of the gaseous substance and/or the position of the nozzles is separately optimized in each section.

5. A method according to claim 1, wherein the different sections are selected according to the local orientation of the perimeter with respect to the relative velocity vector.

6. A method according to claim 5, wherein the sections are divided in a side part, an advancing part and a receding part.

7. A method according to claim 1 wherein the tensio-active gaseous substance is one of the group consisting of isopropylalcohol, further abbreviated as IPA, butanol, ethanol, hexanol, or a mixture thereof.

8. A method according to claim 7 wherein the tensio-active gaseous substance comprises IPA vapor.

9. A method according to claim 8 wherein the tensio-active gaseous substance comprises IPA vapor and a vapor of the immersion liquid.

10. A method according to claim 7 wherein the gaseous substance further comprises an inert gas like helium, argon, nitrogen or equivalents.

11. A method according to claim 10 wherein the tensio-active gaseous substance comprises a mixture of IPA and N₂ vapor.

12. A method according to claim 1, wherein supplying the tensio-active gaseous substance comprises providing a jet directed to the perimeter of the contact area.

13. A method according to claim 12, wherein the tensio-active gaseous substance is supplied through a narrow slit-shaped outlet directed to the perimeter of the contact area and mounted around the immersion head assembly.

14. A method according to claim 1, wherein supplying the immersion liquid comprises supplying the immersion liquid at one side of the optical immersion head assembly and drain it away at the other side.

15. A method according to claim 1, further comprising the step of recirculating the immersion liquid.

16. A method according to claim 1, further comprising the step of treating (e.g. regenerate, purify, filter, degas, etc.) the immersion liquid.

17. An apparatus for immersion lithography comprising
- means for holding a substrate
- an optical immersion head assembly
- means for supplying an immersion liquid between the substrate and the optical immersion head assembly
**characterized in that** said apparatus further comprises :
- means for supplying a tensio-active gaseous substance, arranged for providing a tensio-active gaseous substance along the perimeter of the contact area of the immersion liquid and the substrate, such that upon supply a surface tension gradient is created pulling the immersion liquid from the perimeter towards the contact area, wherein the presence of said tensio-active substance creates a three-phase region along said perimeter, and wherein the means for supplying a tensio-active substance are arranged for supplying said substance with a gas flow directed to said three phase region, and wherein the means for supplying the tensio-active gaseous substance are separated in different sections along the perimeter of the contact area.

18. An apparatus according to claim 17, wherein in each section the means for supplying the tensio-active gaseous substance are suitable for separately optimizing the confinement of the immersion liquid.

19. The apparatus according to claim 17 or 18, wherein separate nozzles are provided in each of said different sections.

20. An apparatus according to claim 17, wherein the different sections are selected according to the local orientation of the perimeter with respect to the relative velocity vector.

21. An apparatus according to claim 20, wherein the sections are divided in a side part, an advancing part and a receding part.

22. An apparatus according to claim 17, wherein the means for supplying the tensio-active gaseous substance comprise a device providing a jet directed to the perimeter of the contact area.

23. An apparatus according to claim 22, wherein the device comprises a nozzle with a narrow slit-shaped outlet directed to the perimeter of the contact area and mounted around the immersion head assembly.

24. An apparatus according to claim 17, wherein the means for supplying the immersion liquid are arranged to supply the immersion liquid at one side of the optical immersion head assembly and drain it away at the other side.

25. An apparatus according to claim 17, further comprising a recirculation device, optionally arranged to treat the immersion liquid.

## Patentansprüche

1. Verfahren zur Immersionslithographie, umfassend die folgenden Schritte:
- Positionieren eines Halbleitersubstrats unter einem optischen Immersionskopfaufbau,
- Bereitstellen einer Immersionsflüssigkeit zwischen dem Substrat und dem optischen Immersionskopfaufbau, wobei die Immersionsflüssigkeit zumindest mit einem Bereich des Substrats in Kontakt steht,
**dadurch gekennzeichnet, dass** das Verfahren ferner den folgenden Schritt umfasst:
- Zuführen eines tensioaktiven gasförmigen Stoffs entlang des Umfangs des Kontaktbereichs der Immersionsflüssigkeit und des Substrats, wobei der tensioaktive gasförmige Stoff so gewählt wird, dass er bei einer zumindest teilweisen Mischung mit der Immersionsflüssigkeit ein Gemisch mit einer niedrigeren Oberflächenspannung als jener der Immersionsflüssigkeit ergibt, wodurch ein Oberflächenspannungsgefälle erzeugt wird, das die Immersionsflüssigkeit vom Umfang zum Kontaktbereich zieht, wobei das Vorhandensein des tensioaktiven Stoffs einen Dreiphasenbereich entlang des Umfangs erzeugt, und wobei der tensioaktive gasförmige Stoff mit einem Gasstrom, der zum Dreiphasenbereich gerichtet ist, zugeführt wird, und wobei der tensioaktive gasförmige Stoff in verschiedenen Abschnitten entlang des Umfangs des Kontaktbereichs gesondert zugeführt wird.

2. Verfahren nach Anspruch 1, wobei die Begrenzung der Immersionsflüssigkeit in jedem Abschnitt gesondert optimiert wird.

3. Verfahren nach Anspruch 1 oder 2, wobei der gasförmige Stoff in jedem der verschiedenen Abschnitte durch gesonderte Düsen zugeführt wird.

4. Verfahren nach Anspruch 3, wobei die Fließgeschwindigkeit des gasförmigen Stoffs und/oder die Position der Düsen in jedem Abschnitt gesondert optimiert werden.

5. Verfahren nach Anspruch 1, wobei die verschiedenen Abschnitte gemäß der lokalen Ausrichtung des Umfangs in Bezug auf den relativen Geschwindigkeitsvektor gewählt werden.

6. Verfahren nach Anspruch 5, wobei die Abschnitte in einen Seitenteil, einen vorrückenden Teil und einen zurückweichenden Teil geteilt sind.

7. Verfahren nach Anspruch 1, wobei der tensioaktive gasförmige Stoff einer der Stoffe der Gruppe bestehend aus Isopropylalkohol, abgekürzt IPA, Butanol, Ethanol, Hexanol oder einem Gemisch davon besteht ist.

8. Verfahren nach Anspruch 7, wobei der tensioaktive gasförmige Stoff IPA-Dampf umfasst.

9. Verfahren nach Anspruch 8, wobei der tensioaktive gasförmige Stoff IPA-Dampf und einen Dampf der Immersionsflüssigkeit umfasst.

10. Verfahren nach Anspruch 7, wobei der gasförmige Stoff ferner ein Inertgas wie Helium, Argon, Stickstoff oder Äquivalente umfasst.

11. Verfahren nach Anspruch 10, wobei der tensioaktive gasförmige Stoff ein Gemisch aus IPA und N₂-Dampf umfasst.

12. Verfahren nach Anspruch 1, wobei das Zuführen des tensioaktiven gasförmigen Stoffs das Bereitstellen eines Strahls umfasst, der auf den Umfang des Kontaktbereichs gerichtet ist.

13. Verfahren nach Anspruch 12, wobei der tensioaktive gasförmige Stoff durch einen schmalen schlitzförmigen Auslass zugeführt wird, der auf den Umfang des Kontaktbereichs gerichtet ist und um den Immersionskopfaufbau angebracht ist.

14. Verfahren nach Anspruch 1, wobei das Zuführen der Immersionsflüssigkeit das Zuführen der Immersionsflüssigkeit an einer Seite des optischen Immersionskopfaufbaus und ihr Ablaufen an der anderen Seite umfasst.

15. Verfahren nach Anspruch 1, ferner umfassend den Schritt des Rückführens der Immersionsflüssigkeit.

16. Verfahren nach Anspruch 1, ferner umfassend den Schritt des Behandelns (z.B. Regenerierens, Reinigens, Filterns, Entgasens usw.) der Immersionsflüssigkeit.

17. Vorrichtung für die Immersionslithographie, umfassend:
- ein Mittel zum Halten eines Substrats,
- einen optischen Immersionskopfaufbau,
- ein Mittel zum Zuführen einer Immersionsflüssigkeit zwischen dem Substrat und dem optischen Immersionskopfaufbau,
**dadurch gekennzeichnet, dass** die Vorrichtung ferner Folgendes umfasst:
- ein Mittel zum Zuführen eines tensioaktiven gasförmigen Stoffs, das dazu eingerichtet ist, entlang des Umfangs des Kontaktbereichs der Immersionsflüssigkeit und des Substrats einen tensioaktiven gasförmigen Stoff bereitzustellen, so dass bei der Zuführung ein Oberflächenspannungsgefälle erzeugt wird, das die Immersionsflüssigkeit vom Umfang zum Kontaktbereich zieht, wobei das Vorhandensein des tensioaktiven Stoffs einen Dreiphasenbereich entlang des Umfangs erzeugt, und wobei das Mittel zum Zuführen eines tensioaktiven Stoffs dazu eingerichtet ist, den Stoff mit einem Gasstrom, der zum Dreiphasenbereich gerichtet ist, zuzuführen, und wobei das Mittel zum Zuführen des tensioaktiven gasförmigen Stoffs in verschiedene Abschnitte geteilt ist entlang des Umfangs des Kontaktbereichs.

18. Vorrichtung nach Anspruch 17, wobei das Mittel zum Zuführen des tensioaktiven gasförmigen Stoffs in jedem Abschnitt dazu geeignet ist, die Begrenzung der Immersionsflüssigkeit gesondert zu optimieren.

19. Vorrichtung nach Anspruch 17 oder 18, wobei in jedem der verschiedenen Abschnitte gesonderte Düsen bereitgestellt sind.

20. Vorrichtung nach Anspruch 17, wobei die verschiedenen Abschnitte gemäß der lokalen Ausrichtung des Umfangs in Bezug auf den relativen Geschwindigkeitsvektor gewählt werden.

21. Vorrichtung nach Anspruch 20, wobei die Abschnitte in einen Seitenteil, einen vorrückenden Teil und einen zurückweichenden Teil geteilt sind.

22. Vorrichtung nach Anspruch 17, wobei das Mittel zum Zuführen des tensioaktiven gasförmigen Stoffs eine Vorrichtung umfasst, die einen Strahl bereitstellt, der auf den Umfang des Kontaktbereichs gerichtet ist.

23. Vorrichtung nach Anspruch 22, wobei die Vorrichtung eine Düse mit einem schmalen schlitzförmigen Auslass umfasst, die auf den Umfang des Kontaktbereichs gerichtet ist und um den Immersionskopfaufbau angebracht ist.

24. Vorrichtung nach Anspruch 17, wobei das Mittel zum Zuführen der Immersionsflüssigkeit so angeordnet ist, dass es die Immersionsflüssigkeit an einer Seite des optischen Immersionskopfaufbaus zuführt und sie an der anderen Seite ablaufen lässt.

25. Vorrichtung nach Anspruch 17, ferner umfassend eine Rückführungsvorrichtung, die optional eingerichtet ist, um die Immersionsflüssigkeit zu behandeln.

## Revendications

1. Procédé de lithographie par immersion comprenant les étapes consistant à :
- positionner un substrat semi-conducteur sous un ensemble de têtes d'immersion optique,
- fournir un liquide d'immersion entre le substrat et l'ensemble de têtes d'immersion optique, le liquide d'immersion étant au moins en contact avec une zone du substrat,
**caractérisé en ce que** le procédé comprend en outre l'étape consistant à :
- approvisionner une substance gazeuse tensioactive le long du périmètre de la zone de contact du liquide d'immersion et du substrat, moyennant quoi la substance gazeuse tensioactive est choisie de telle sorte que, lorsqu'elle est au moins en partie mélangée avec le liquide d'immersion, elle produit un mélange ayant une tension superficielle inférieure à celle du liquide d'immersion, créant ainsi un gradient de tension superficielle tirant le liquide d'immersion du périmètre vers la zone de contact, dans lequel la présence de ladite substance tensioactive crée une région à trois phases le long dudit périmètre, et dans lequel la substance gazeuse tensioactive est approvisionnée avec un écoulement gazeux dirigé vers ladite région à trois phases et dans lequel la substance gazeuse tensioactive est approvisionnée de manière séparée dans des sections différentes le long du périmètre de la zone de contact.

2. Procédé selon la revendication 1, dans lequel le confinement du liquide d'immersion est optimisé de manière séparée dans chaque section.

3. Procédé selon la revendication 1 ou 2, dans lequel la substance gazeuse est approvisionnée à travers des buses séparées dans chacune desdites sections différentes.

4. Procédé selon la revendication 3, dans lequel le débit de la substance gazeuse et/ou la position des buses sont optimisés de manière séparée dans chaque section.

5. Procédé selon la revendication 1, dans lequel les sections différentes sont sélectionnées selon l'orientation locale du périmètre par rapport au vecteur de vitesse relative.

6. Procédé selon la revendication 5, dans lequel les sections sont divisées en une partie latérale, une partie d'avancée et une partie de recul.

7. Procédé selon la revendication 1, dans lequel la substance gazeuse tensioactive appartient au groupe constitué par l'alcool isopropylique, abrégé en IPA ci-après, le butanol, l'éthanol, l'hexanol ou un mélange de ceux-ci.

8. Procédé selon la revendication 7, dans lequel la substance gazeuse tensioactive comprend de la vapeur d'IPA.

9. Procédé selon la revendication 8, dans lequel la substance gazeuse tensioactive comprend de la vapeur d'IPA et une vapeur du liquide d'immersion.

10. Procédé selon la revendication 7, dans lequel la substance gazeuse tensioactive comprend en outre un gaz inerte tel que l'hélium, l'argon, l'azote ou des équivalents.

11. Procédé selon la revendication 10, dans lequel la substance gazeuse tensioactive comprend un mélange d'IPA et de vapeur de N₂.

12. Procédé selon la revendication 1, dans lequel l'approvisionnement de la substance gazeuse tensioactive comprend la fourniture d'un jet dirigé vers le périmètre de la zone de contact.

13. Procédé selon la revendication 12, dans lequel la substance gazeuse tensioactive est approvisionnée à travers un orifice d'évacuation étroit en forme de fente dirigé vers le périmètre de la zone de contact et monté autour de l'ensemble de têtes d'immersion.

14. Procédé selon la revendication 1, dans lequel l'approvisionnement du liquide d'immersion comprend l'approvisionnement du liquide d'immersion d'un côté de l'ensemble de têtes d'immersion optique et son drainage de l'autre côté.

15. Procédé selon la revendication 1, comprenant en outre l'étape consistant à remettre en circulation le liquide d'immersion.

16. Procédé selon la revendication 1, comprenant en outre l'étape consistant à traiter (par ex. régénérer, purifier, filtrer, dégazer, etc.) le liquide d'immersion.

17. Appareil de lithographie par immersion comprenant
- des moyens pour maintenir un substrat,
- un ensemble de têtes d'immersion optique,
- des moyens pour approvisionner un liquide d'immersion entre le substrat et l'ensemble de têtes d'immersion optique, **caractérisé en ce que** ledit appareil comprend en outre :
- des moyens pour approvisionner une substance gazeuse tensioactive, agencés pour fournir une substance gazeuse tensioactive le long du périmètre de la zone de contact du liquide d'immersion et du substrat, de sorte que, lors de l'approvisionnement, un gradient de tension superficielle est créé en tirant le liquide d'immersion du périmètre vers la zone de contact, dans lequel la présence de ladite substance tensioactive crée une région à trois phases le long dudit périmètre, et dans lequel les moyens pour approvisionner une substance tensioactive sont agencés pour approvisionner ladite substance avec un écoulement gazeux dirigé vers ladite région à trois phases, et dans lequel les moyens pour approvisionner la substance gazeuse tensioactive sont séparés dans des sections différentes le long du périmètre de la zone de contact.

18. Appareil selon la revendication 17, dans lequel dans chaque section les moyens pour approvisionner la substance gazeuse tensioactive sont appropriés pour optimiser de manière séparée le confinement du liquide d'immersion.

19. Appareil selon la revendication 17 ou 18, dans lequel des buses séparées sont fournies dans chacune des sections différentes.

20. Appareil selon la revendication 17, dans lequel les différentes sections sont sélectionnées selon l'orientation locale du périmètre par rapport au vecteur de vitesse relative.

21. Appareil selon la revendication 20, dans lequel les sections sont divisées en une partie latérale, une partie d'avancée et une partie de recul.

22. Appareil selon la revendication 17, dans lequel les moyens pour approvisionner la substance gazeuse tensioactive comprennent un dispositif fournissant un jet dirigé vers le périmètre de la zone de contact.

23. Appareil selon la revendication 22, dans lequel le dispositif comprend une buse ayant un orifice d'évacuation étroit en forme de fente dirigé vers le périmètre de la zone de contact et monté autour de l'ensemble de têtes d'immersion.

24. Appareil selon la revendication 17, dans lequel les moyens pour approvisionner le liquide d'immersion sont agencés pour approvisionner le liquide d'immersion d'un côté de l'ensemble de têtes d'immersion optique et le drainer de l'autre côté.

25. Appareil selon la revendication 17, comprenant en outre un dispositif de remise en circulation, facultativement agencé pour traiter le liquide d'immersion.
